Europäisches Patentamt

European Patent Office

Office européen des brevets

(11) Veröffentlichungsnummer: **0 304 395**
**A1**

## EUROPÄISCHE PATENTANMELDUNG

(21) Anmeldenummer: **88730183.6**

(22) Anmeldetag: **15.08.88**

(51) Int. Cl.4: **H 05 K 9/00**
**E 06 B 5/18**

(30) Priorität: **20.08.87 DE 3728055**

(43) Veröffentlichungstag der Anmeldung:
**22.02.89 Patentblatt 89/08**

(84) Benannte Vertragsstaaten: **AT DE FR GB**

(71) Anmelder: **ABS Allgemeiner Brandschutz G. u. M.**
**Breivogel GmbH**
**Robert-Koch-Strasse 21**
**D-6500 Mainz 42 (DE)**

(72) Erfinder: **Richter, Klaus**
**Pariser Strasse 19**
**D-1000 Berlin 15 (DE)**

(74) Vertreter: **Pfenning, Meinig & Partner**
**Kurfürstendamm 170**
**D-1000 Berlin 15 (DE)**

(54) **Kombinations-Schutzraum.**

(57) Es wird ein Kombinations-Schutzraum gegen die Einwirkung von Wärme im Brandfall, von Wasser- und Wasserdampf und Gas und von magnetischen und elektrischen Feldern vorgeschlagen, der aus Wandungen mit mehreren Schichten aus Brandschutzmaterialien, die nicht miteinander verbunden und selbsttragen sind, und einer innenliegenden Metallhülle aus einzelnen Blechelementen (H) besteht. Der Kombinations-Schutzraum weist weiterhin eine Brandschutztür (12) mit durchgehender Metallplatte (14) auf, wobei die Übergangsstellen zwischen den einzelnen Blechelementen (4) und zwischen Blechelementen (4) und Metallplatte (14) der Brandschutztür (12) mit Dampf-Gasdichtungen (7, 20, 21, 25) versehen sind, die elektrisch und magnetisch leitend und elastisch sind.

FIG.1

Bundesdruckerei Berlin

**Beschreibung**

## KOMBINATIONS-SCHUTZRAUM

Die Erfindung betrifft einen Kombinations-Schutzraum gegen die Einwirkung von Wärme im Brandfall, von Wasser- und Wasserdampf bzw. Gas unter Druck und von magnetischen und elektrischen Feldern vom Mittel- bis Höchstfrequenzbereich.

In der Vergangenheit sind einige Fortschritte auf dem Gebiet des Brandschutzes in Bezug auf begehbare Brandschutzräume gemacht worden, die insbesondere zur Lagerung von Datenträgern dienen EP 85730092.5. Bei diesem bekannten Brandschutzraum sind die den Innenraum umgebenden Wandungen aus mehreren Wärmedämm- und Isolierschichten, wie Brandschutzplatten, Gipskartonplatten und/oder Steinfaserplatten oder dergleichen aufgebaut, die unabhängig voneinander errichtet und selbsttragend sind und mechanisch nicht miteinander verbunden sind, wobei zwischen ihnen ein Stützenwerk aus metallischen Profilträgern angeordnet ist und auf der Innenseite Blechelemente vorgesehen sind.

Damit ein ausreichender Brandschutz auch an den Übergangsbereichen zwischen innen und außen, das heißt, im Bereich der Tür gewährleistet wird, sind besondere Türelemente (deutsche Patentanmeldung P 36 40 467.5, deutsche Patentanmeldung P 36 40 466.7) entwickelt worden, die ebenfalls aus mehreren Wärmedämm- und Isolierschichten bestehen und ebenso wie die die Türöffnung umgebende Laibung mehrfach abgestuft und gefalzt sind. Dabei wird die Tür an Tragarmen gehalten, die Bestandteil einer im Innenraum vor der Wand angeordneten Tragkonstruktion sind, so daß die Last der Tür nicht auf die Wand bzw. Decke des Schutzraumes wirkt. Mittels Steuerhebel bewegt sich die Tür beim Öffnen erst parallel zur Türöffnung nach außen und schwenkt anschließend herum. Die bekannten Türelemente weisen eine Betätigungsvorrichtung auf, die sowohl von innen als auch von außen betätigt werden kann, wobei eine durch die Türwandung hindurchgehende Welle vorgesehen ist, die eine brandschutzmäßige Trennung aufweist. Es hat sich gezeigt, daß derartige bekannte Brandschutzräume mit den beschriebenen Türelementen sehr gut alle Brandschutzbedingungen erfüllen.

Abhörschutzräume sind ebenfalls allgemein bekannt, bei denen ein Schutz gegen die Weiterleitung von elektrischen und magnetischen Feldern des Radio- und Funkfrequenzbereiches durch metallische Abschirmungen realisiert werden.

Es ist bisher aber kein Schutzraum bekannt, der die Schutzbedürfnisse gegen hohe Temperaturen und ungewünschte Wärmeübergänge, gegen die Einwirkung von Wasser- und Wasserdampf bzw. Gas und gegen elektromagnetische Störfelder gleichzeitig befriedigt. Dies liegt daran, daß diese drei Aufgabenstellungen im einzelnen für ihre Lösungen zwanghaft jeweils unterschiedliche Materialien benötigen, die den Lösungen der jeweils anderen Aufgabenstellungen durch ihre technisch physikalischen Voraussetzungen entgegenstehen und entgegenwirken, so daß bisher kein Versuch unternommen wurde, alle drei Schutzbedürfnisse zu vereinigen.

Der Erfindung liegt daher die Aufgabe zugrunde, einen Kombinations-Schutzraum, beispielsweise für ein sicheres Arbeiten mit Datenverarbeitungsanlagen zu schaffen, der auch bei hohen Außentemperaturen im Brandfall keine übermäßige Temperaturerhöhung im Innenraum zuläßt, der dampfdicht und gleichzeitig "dicht" gegen elektromagnetische Felder ist und die bekannten Lösungsprinzipien des Brandschutzes, der Wasserdampfdichtigkeit und der elektromagnetischen Abschirmung in einer Konstruktion vereinten.

Diese Aufgabe wird durch die im Hauptanspruch angegebene Kombination gelöst.

Durch Vorsehen eines Raumes mit Wandungen aus mehreren Schichten aus Brandschutzmaterialien, die nicht miteinander verbunden und selbsttragend sind, wobei eine innenliegende Metallhülle aus einzelnen Blechelementen vorgesehen ist, zwischen denen Dampf-Gasdichtungen angeordnet sind, die elektrisch und magnetisch leitend und elastisch sind, wird ein gasdichter und elektromagnetisch "dichter" Raum zur Verfügung gestellt, der keine großen Wärmeübergänge von außen nach innen zuläßt, wobei die die Durchgangsöffnung in den Raum verschließende Brandschutztür eine innenliegende Metallplatte aufweist, die ebenfalls gasdicht und elektromagnetisch leitend mit den sie umgebenden Blechelementen verbunden ist.

Durch die in den Unteransprüchen angegebenen Maßnahmen sind vorteilhafte Weiterbildungen und Verbesserungen möglich.

Vorteilhafterweise besteht die Dampf-Gasdichtung aus einem gummielastischen Mittelelement und Seitenteilen aus einem Gewirk bzw. Geflecht aus dünnen metallischen Drähten, wobei durch das Verhältnis Hohlraum im Gewirk zum Andruck im eingebauten Zustand die erforderliche Dämpfung bestimmt werden kann. Es hat sich gezeigt, daß sich die günstigsten Abschirmwerte ergeben, wenn das Metallgewirk vorzugsweise aus verkupferten und anschließend verzinnten Stahldrähten im eingebauten Zustand auf 1/3 seiner ursprünglichen Dicke zusammengedrückt wird. Damit selbst bei unfachgerechter Montage ein übermäßiges Anziehen der Verbindungsschrauben zwischen den mit der Dampf-Gasdichtung zu versehenden Bauelementen ein zu starkes Zusammenpressen des Metallgewirks, dessen Abschirmwirkung sich über ein bestimmtes Verdichtungsverhältnis hinaus erheblich verschlechtert, vermieden wird, sind eine oder mehrere Einlagen in das gummielastische Element eingebettet, die ein Zusammenpressen über ein bestimmtes Maß verhindern.

Eine sichere Abdichtung an der Tür wird durch Hereinfahren einer umlaufenden Schneide zwischen zwei metallische Federn erzielt, die mit der Metallplatte der Tür verbunden sind, wobei die Schneide sich zusätzlich in einen gummielastischen Dichtungsstreifen drückt.

Damit die elektromagnetischen Wellen nicht durch die für die Betätigung der Tür notwendigen Durchgriff hindurchdringen können, ist vorteilhafterweise ein die Betätigungswelle umgreifendes Stahlrohr vorgesehen, das mit der Metallplatte der Tür dicht verbunden ist, wobei innerhalb des Stahlrohres die Betätigungswelle aus Kunststoff besteht. Eine ausreichende Dämpfung der elektromagnetischen Wellen ist dann gewährleistet, wenn der Innendurchmesser des Stahlrohres kleiner oder gleich 3 cm ist und wenn seine Länge größer oder gleich dem Vierfachen des Innendurchmessers ist. Die Dampfdichtigkeit wird durch eine zwischen Betätigungswelle und Stahlrohr zum kalten Ende hin angeordnete gummielastische Dichtung gewährleistet. Für einen ausreichenden Brandschutz kann das außengerichtete Ende des Stahlrohres mit einem im Brandfall aufschäumbaren Material versehen sein.

Da üblicherweise im Raum, der beispielsweise Datenverarbeitungsanlagen oder dergleichen enthalten kann, bei geschlossener Tür gearbeitet wird, muß eine mit einer Klimaanlage verbundene Klimaklappe vorgesehen sein. Der Brandschutz und der Schutz gegen das Eindringen von Wasserdampf oder Gas, muß bei geschlossener Tür und geschlossener Klimaklappe wirksam sein, während der Abhörschutz aber bei geschlossner Tür und offener Klimaklappe gewährleistet sein muß. Daher ist gemäß der Erfindung in vorteilhafter Weise der Klimakanal als Blechkanal ausgebildet, in dessen Strömungsquerschnitt ein bekannter Wabenkamineinsatz eingesetzt und mit dem Blechkanal verbunden ist. Der Blechkanal setzt sich mehrfach abgewinkelt, unter Zwischenschaltung von den elektrisch und magnetisch leitenden elastischen Dampf-Gasdichtungen zwischen Zarge und Klimaklappe und Wandungen bis zu den innenliegenden Blechelementen fort, wobei aufgrund der Dämpfungseigenschaften der elektromagnetischen Wellen zumindest teilweise ein sehr dünnes Blech gewählt werden kann, so daß der Brandschutz nicht wesentlich verschlechtert wird.

Die Erfindung ist in der Zeichnung dargestellt und wird in der nachfolgenden Beschreibung näher erläutert.
Es zeigen:

Fig. 1 einen Teilschnitt durch eine Wandung des Kombinations-Schutzraumes,

Fig. 2 einen Schnitt durch einen Teil der Tür und der angrenzenden Wandung mit elektrisch und magnetisch leitender Dampf-Gasdichtung,

Fig. 3 einen Schnitt durch einen Teil der Tür mit einem Teil der Betätigungsvorrichtung und

Fig. 4 einen Teilschnitt durch den Klimakanal mit Verbindung zur inneren Metallhülle.

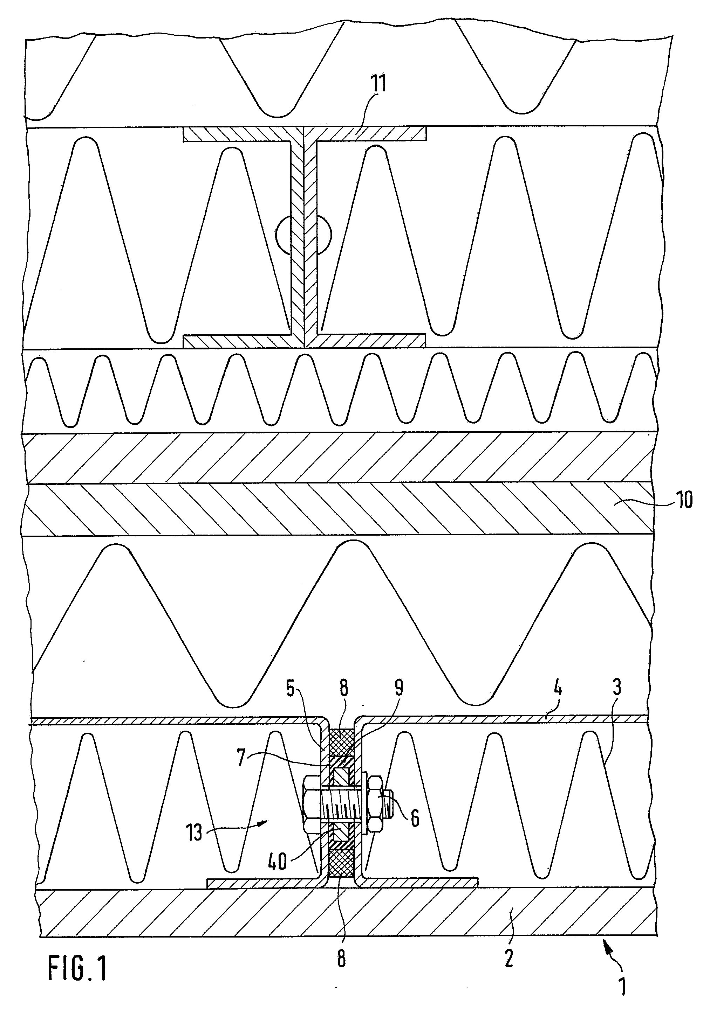

Die in Figur 1 dargestellte Wand weist einen Mehrschichtaufbau auf, der ebenfalls für die Decke des Kombinations-Schutzraumes gilt. Die dem Innenraum 2 zugewandte Fläche, die im wesentlichen der optischen Verkleidung dient, kann von der Oberfläche einer Schicht 2 aus Gipskartonplatten oder Holz oder dergleichen gebildet sein. Angrenzend an die Innenschicht 2 ist eine Wärmedämmschicht 3 vorgesehen, die in Blechelemente 4 eingelegt ist, die an ihren Stoßstellen U-förmig ausgebildet ist, wobei die Böden 5 der einzelnen Blechelemente 4 durch Schrauben 6, Bolzen oder dergleichen verbunden sind. Zwischen den Blechelementen 4 ist eine Dichtung 7 vorgesehen, die sowohl elektrisch und magnetisch leitend ist, als auch elastisch und dampf- bzw. gasdicht. Die Blechelemente dienen zur Abschirmung der elektromagnetischen Wellen und bestehen vorzugsweise aus verzinktem Stahlblech mit einer Dicke von 1,25 mm. Die Blechdicke bestimmt sich aus der notwendigen Dämpfung der elektromagnetischen Wellen im Frequenzbereich von mindestens 10 kHz bis 10 GHz.

Die Dichtung 7, die die elektromagnetische Abschirmung durch die Blechelemente nicht unterbrechen darf, ist streifenförmig ausgebildet und besteht aus einem Kern oder Mittelstück 9 aus Gummi oder anderem gummielastischen Material und aus Seitenteilen 8 aus einem Gewirk aus dünnen metallischen Drähten, vorzugsweise vernickelten verkupferten Stahldrähten nach Art von Drahtwolle. Die Seitenteile 8 sind mit dem Mittelteil 9 durch Klebung miteinander verbunden oder sie sind anvulkanisiert. Die durch das Drahtgewirk gebildeten Hohlräume der Seitenteile sind für die Dämpfung ebenso ausschlaggebend wie die Drähte selbst, wobei das Verhältnis von Hohlräumen zu dem Andruck die erforderliche Dämpfung bestimmt, die 60 dB für das magnetische Feld und 100 dB für das elektrische Feld betragen sollte. Sehr gute Abschirmwerte ergeben sich, wenn das Metallgewirk 8 auf 1/3 seiner ursprünglichen Ausgangsdichte zusammengedrückt wird. In das Mittelstück 9 aus Gummi sind an den Bohrungsstellen für die Verschraubungen 6 Unterlegscheiben 40 einvulkanisiert, die derart bemessen sind, daß im zusammengeschraubten Zustand das Metallgewirk auf das gewünschte Maß zusammengedrückt ist und dabei gleichzeitig das Mittelstück aus Gummi wasserdampfdichtend wirkt. Die Unterlegscheiben haben daher vorzugsweise eine Dicke, die etwa 1/3 der Dicke des Metallgewirks beträgt.

In einem anderen Ausführungsbeispiel der Dichtung 7 besteht sie durchgehend aus dem Drahtgewirk, wobei in das Mittelteil Gummi oder gummielastischem Material eingegossen oder in anderer Weise eingearbeitet ist.

Wie weiter aus der Fig. 1 zu erkennen ist, besteht die Wand aus weiteren Schichten 10, die als Wärmedämmaterialien unterschiedlicher Arten ausgebildet sind, wobei zusätzlich noch Gipskartonplatten eigearbeitet sein können. Weiterhin ist nach einigen Schichten 10 ein Stützenwerk 11 aus Metallprofilen, beispielsweise U-Trägern, die miteinander verbunden sind, vorgesehen, wobei in die Profile wiederum Wärmedämmaterial eingelegt ist. Die einzelenen Schichten des sandwichartigen Aufbaus der Wandungen sind nicht miteinander verbunden und tragen sich selbst, also daß ein Wärmetransport nicht über etwaige Verbindungselemente erfolgen kann.

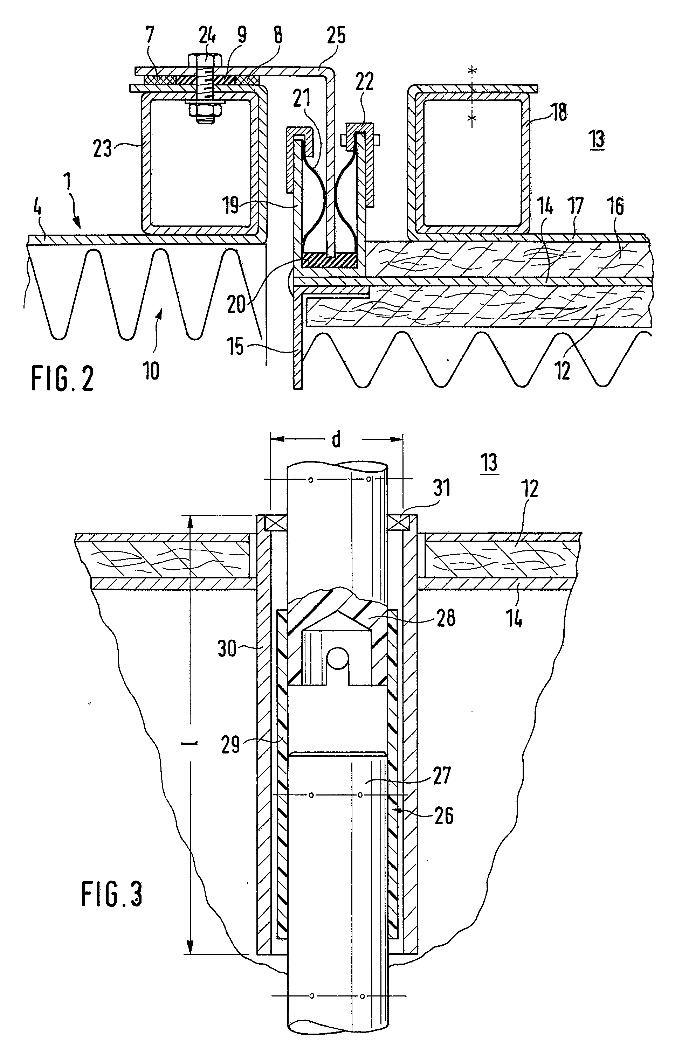

In Fig. 2 ist ein Teil einer Brandschutztür 12 dargestellt, die in die Wand 1 eingesetzt ist, wobei die einzelnen Schichten sowohl der Wand als auch der Tür 12 nicht näher dargestellt sind, da sie denen der Fig. 1 entsprechen. Die Tür 12 ist zum Innenraum 13 hin mit einer durchgehenden Metallplatte 14 versehen, die mit dem Türwinkel 15 verschweißt ist, wobei eine direkte Sicht auf die Metallplatte 14 vom Innenraum 13 her durch eine Gipskartonplatte 16 und zusätzlich eine Schicht aus verzinktem Blech 17, das mit einem Vierkantrohr 10 verschraubt ist, verdeckt wird. Umlaufend um die gesamte Tür herum ist ein U-Profil 19 mit der Metallplatte 14 beispielsweise durch Schweißen verbunden.

In dem Boden des U-Profils 19 ist ebenfalls umlaufend ein Dichtungsstreifen 20 aus weichem Gummi oder dergleichen fest eingelegt. Seitlich an dem U-Profil 19 sind zwei dünne umlaufende Metallfedern 21, vorzugsweise aus Bronze Beryllium, unter Spannung, beispielsweise durch Klemmstücke 22, sich gegenüberstehend, befestigt.

Um die Türöffnung herum ist ein Vierkantrohr 23 vorgesehen, das mit den angrenzenden Blechelementen verbunden ist, wobei das Vierkantrohr 23 in die abgewinkelten Enden der Blechelemente 4 eingesetzt ist. Über Schrauben 24 unter Zwischenschaltung der streifenförmigen elektrisch und magnetisch leitenden Dampf-Gasdichtung 7 ist eine abgewinkelte Schneide 25 mit dem Blechelement 4 bzw. dem Vierkantrohr 24 verbunden. Die Schneide 25 läuft ebenfalls um die gesamte Türöffnung herum und greift bei geschlossener Tür in das U-Profil 19 zwischen die Metallfedern 21 ein und drückt sich in den Dichtungsstreifen 20 ein. Die Gasdichtigkeit zwischen Tür und Wand wird somit durch die den Dichtungsstreifen 20 sich drückenden Schneide 25 und durch den Mittelteil 9 der Dichtung 7 zwischen Schneide 25 und Blechelement 4 gewährleistet, während die elektrische und magnetische Verbindung über den Kontakt der Schneide 25 mit den Metallfedern 21 und über das Drahtgewirk 8 der Dichtung 7 gegeben ist. Beim Öffnen der Tür 12 bewegt sie sich nach Fig. 2 parallel zur Wand 1 und zur Türöffnung nach vorn, so daß die Schneide aus dem U-Profil herausrutscht und der Kontakt zwischen Metallfedern 21 und Schneide 25 sich löst. Erst nachdem eine vollständige Trennung vorgenommen ist, wird die Tür geschwenkt. In entsprechender Weise wird beim Schließen der Tür vorgegangen.

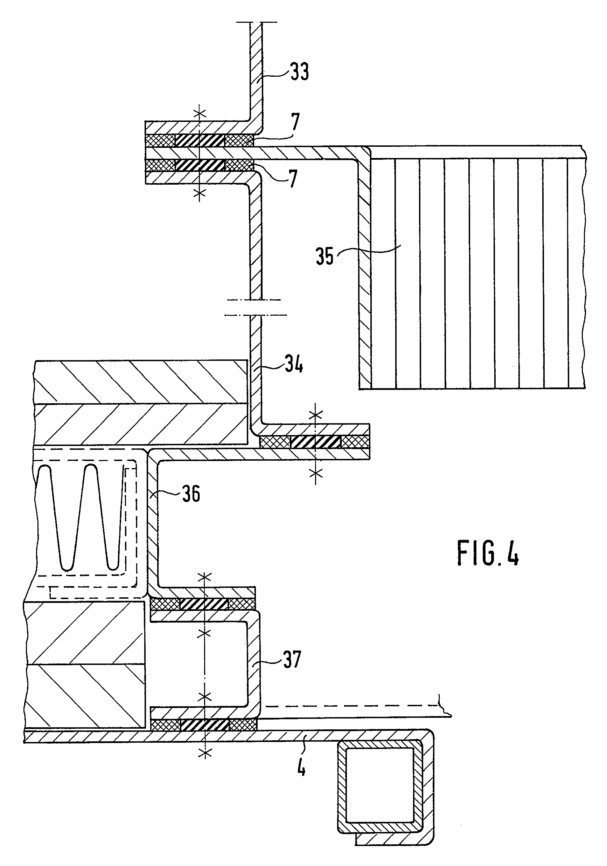

In Fig. 4 ist ein Teil der Tür 12 dargestellt, wobei ein Teil der Betätigungsvorrichtung für die Tür gezeigt ist. Die Tür 12 kann sowohl von innen 13, als auch von außen geöffnet werden wofür eine Welle 26 vorgesehen ist. Die Welle 26 besteht aus zwei Teilwellen 27, 28 die zwischen sich einen Abstand aufweisen, wobei die Verbindung zwischen beiden Teilwellen 27, 28 über eine Kunststoffhülse 29 erfolgt. Für die elektromagnetische Abschirmung ist ein Rohr vorzugsweise aus Stahl vorgesehen, das mit der Metallplatte 14 dicht verschweißt ist. Am Ende des Rohres 29 ist zwischen Teilwelle 28 und Stahlrohr 30 eine Dampf- und Gasdichtung angeordnet. Für eine effektive Abschirmung ist es wichtig, daß das Stahlrohr 30 einen Innendurchmesser d von 3 cm oder weniger aufweist, während die Länge 1 des Stahlrohres größer oder gleich dem vierfachen Innendurchmesser betragen soll, wobei im inneren des Stahlrohres kein Metall enthalten sein darf. Das bedeutet, daß die Teilwellen 27, 28 und die Verbindungen mit der Kunststoffhülse 29 aus Kunststoff bestehen müssen, wobei die Teilwellen 27, 28 außerhalb des Stahlrohres 30 wieder in Stahlwellen übergehen können. Für eine gute Brandschutzdichtung wird das dem Außenraum zugewandte Ende des Stahlrohres von einem im Brandfalle aufschäumbaren Material umgeben.

In Fig. 4 ist die Verbindung der in den Wandungen gemäß Fig. 1 vorgesehenen Klimaklappe mit einem bauseitigen Anschlußkanal 33 einer Klimaanlage.

Dazu wird der Anschlußkanal 33 mit einem Blechkanal aus vorzugsweise 1,25 mm Stahlblech verbunden, wobei die Verbindungsstellen mit der elektrisch und magnetisch leitenden Dampf- und Gasdichtung 7 versehen sind. Zusätzlich ist an den Verbindungsstellen ein bekannter Wabenkamineinsatz 35 eingesetzt, der den Strömungsquerschnitt des Klimakanals gegen elektromagnetische Wellen bis 1 GHz abschirmt. Zwischen Wandung und Klimaklappe, die nicht näher dargestellt ist, sind umlaufend mehrfach abgewinkelte Blechelemente 36, 37 vorgesehen, die über die Dichtungen 7 sowohl miteinander als auch mit dem Blechkanal 34 und den innenliegenden Blechelementen 4 verbunden sind. Diese Blechelemente 36, 37 können aus dünneren Blechen als die übrige Abschirmung bestehen, so daß nur ein geringer Wärmeübergang vorhanden ist.

Bei Berücksichtigung der angegebenen konstruktiven Maßnahmen wird somit ein begehbarer Kombinations-Schutzraum beispielsweise als Arbeitsraum mit Datenverarbeitungsanlagen verfügbar gemacht, der die Bedürfnisse nach Brandschutz, nach Dampfdichtigkeit und nach elektromagnetischer Abschirmung in sicherer Weise erfüllt.

**Patentansprüche**

1. Kombinations-Schuztraum gegen die Einwirkung von Wärme im Brandfall, von Wasser- und Wasserdampf und Gas und von magnetischen und elektrischen Feldern, bestehend aus Wandungen (1) mit mehreren Schichten (10) aus Brandschutzmaterialien, die nicht miteinander verbunden und selbsttragend sind, und mit einer innenliegenden Metallhülle aus einzelnen Blechelementen (4) und aus einer Brandschutztür (12) mit durchgehender Metallplatte (14), wobei die Übergangsstellen zwischen den einzelnen Blechelementen (4) und zwischen den Blechelementen (4) und Metallplatte (14) der Brandschutztür (12) mit Dampf-Gasdichtungen (7,20,21,25) versehen sind, die elektrisch und magnetisch leitend und elastisch sind.

2. Kombinations-Schutzraum nach Anspruch 1, dadurch gekennzeichnet, daß die elektrisch und magnetisch leitende Dampf-Gasdichtung (7) ein Gewirk (8) aus dünnen Metalldrähten aufweist, das mit einem Element (3) aus Gummi oder dergleichen gummielastischem Material verbunden ist.

3. Kombinations-Schutzraum nach Anspruch 2, dadurch gekennzeichnet, daß das Element aus Gummi oder dergleichen gummielastischem Material das Mittelteil (9) der Dichtung (7) bildet, an das das Metallgewirk (8) ein- oder mehrseitig angeklebt oder anvulkanisiert ist.

4. Kombinations-Schutzraum nach Anspruch 2, dadurch gekennzeichnet, daß das Element (9) aus Gummi oder dergleichen gummielastischem Material in die Mitte des Metallgewirks eingearbeitet ist.

5. Kombinations-Schutzraum nach einem der Ansprüche 1 bis 4, dadurch gekennzeichnet, daß die Hohlräume im Gewirk (8) derart gewählt sind, daß bei einem bestimmten Andruck der Dichtung (7) an die abzudichtende Fläche die erforderliche Dämpfung des magnetischen und elektrischen Feldes erzielt wird.

6. Kombinations-Schutzraum nach einem der Ansprüche 1 bis 5, bei dem die Brandschutztür (12) beim Öffnen erst eine Bewegung parallel zur Wand ausführt und dann schwenkt, dadurch gekennzeichnet, daß die Metallplatte (14) mit einem an dem Rand der Tür (14) umlaufenden kanalförmigen Element (19) aus Metall verbunden ist, daß im kanalförmigen Element (19) am Boden ein Dichtungsstreifen (20) aus Gummi oder anderem gummielastischen Material und seitlich zwei sich gegenüberstehende Metallfedern(21)fest angeordnet sind und daß an der die Türöffnung umgrenzenden Innenwand eine umlaufende Metallschneide 25 befestigt ist, die einerseits über die elektrisch und magnetisch leitenden Dampf-Gasdichtungen (7) mit den Blechelementen (4) verbunden ist,und andererseits in die Metallfedern (21) des kanalförmigen Elements (19) eingreift und mit ihrem Ende gegen den Dichtungsstreifen (20) drückt.

7. Kombinations-Schutzraum nach einem der Ansprüche 1 bis 6, wobei durch die Brandschutztür (12) eine zur Betätigung der Tür von innen und außen dienende Welle (26) hindurchgeht, dadurch gekennzeichnet, daß ein mit der Metallplatte (14) umlaufend dicht verbundenes Metallrohr (30) vorzugsweise aus Stahl, die Welle (26) teilweise übergreift, wobei die Welle (26) mindestens in dem übergriffenen Bereich aus Kunststoff besteht,und daß zwischen Metallrohr und Welle im kalten Bereich,im Sinne des Brandschutzes,eine gummielastische Ringdichtung (31) vorgesehen ist.

8. Kombinations-Schutzraum nach Anspruch 7, dadurch gekennzeichnet, daß für eine sichere elektrische Abschirmung der Innendurchmesser d des Metallrohres (30) gleich oder kleiner als 3 cm und die Länge größer oder gleich dem Vierfachen des Innendurchmessers $1 \geqq 4 \, d$ ist.

9. Kombinations-Schutzraum nach einem der Ansprüche 1 bis 8, mit einer Brandschutz-Klimaklappe, deren Öffnung mit einem Anschlußkanal an eine Klimaanlage verbunden ist, dadurch gekennzeichnet, daß der Anschlußkanal (33) mit einem Blechkanal (34) verbunden ist, daß in den Strömungsquerschnitt des Anschlußkanals (33) und des Blechkanals (34) in an sich bekannter Weise ein Wabenkamineinsatz (35) gegen Störfelder eingesetzt ist und daß der Blechkanal (34) mit mehrfach abgewinkelten Blechelementen (36,37) verbunden ist, die zwischen der Wand und der Klimaklappe angeordnet sind und mit den innenliegenden Blechelementen (4) verbunden sind, wobei die Verbindungsstellen zwischen Anschlußkanal (33), Wabenkamineinsatz (35), Blechkanal (34), Blechelementen (36,37) und innenliegende Blechelemente (4) die elektrisch und magnetisch leitenden, elastischen Dampf-Gasdichtungen (7) vorgesehen sind.

10. Kombinations-Schutzraum nach einem der Ansprüche 1 bis 6 oder Anspruch 9, dadurch gekennzeichnet, daß der bestimmte Andruck der elektrisch und magnetisch leitenden Dampf-Gasdichtung (7) aus Gummi oder dergleichen gummielastischem Material im eingebauten Zustand die Dampfdichtigkeit gewährleistet.

11. Kombinations-Schutzraum nach einem der Ansprüche 1 bis 6, Anspruch 9 oder Anspruch 10, dadurch gekennzeichnet, daß in das Element (9) aus Gummi oder dergleichen gummielastischem Material ein oder mehrere als Druckstopp wirkende Einlagen eingebettet sind.

12. Kombinations-Schutzraum nach Anspruch 11, dadurch gekennzeichnet, daß die Einlagen (40) als Unterlegscheiben ausgebildet sind, die an den Bohrungsstellen der Verschraubungen der Bauteile einvulkanisiert sind.

13. Kombinations-Schutzraum nach Anspruch 11 oder 12, dadurch gekennzeichnet, daß die Dicke der Einlage (40) derart bemessen ist, daß im eingebauten Zustand das Metallgewirk auf ein vorbestimmtes Maß zusammengedrückt wird und vorzugsweise etwa 1/3 der Dicke des Metallgewirks (8) entspricht.

14. Kombinations-Schutzraum nach einem der Ansprüche 2 bis Anspruch 6 oder Anspruch 9 bis Anspruch 13, dadurch gekennzeichnet, daß das Metallgewirk aus verkupferten Stahldrähten, die anschließend verzinnt werden, besteht.

FIG.1

FIG. 2

FIG. 3

EP 0 304 395 A1

FIG.4

Europäisches Patentamt

**EUROPÄISCHER RECHERCHENBERICHT**

Nummer der Anmeldung

EP 88 73 0183

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 543 602 (FRANGOLACCI) <br> * Seite 1, Zeilen 26-32 - Seite 2, Zeilen 1-26; Figuren 1-2A * <br> --- | 1,2,3 | H 05 K 9/00 <br> E 06 B 5/18 |
| A | DE-A-3 219 263 (SIEMENS) <br> * Seite 4, Zeilen 30-36; Seite 5, Zeilen 1-21; Figuren 1,2 * <br> --- | 6 | |
| A | US-A-3 783 174 (LINDGREN) <br> --- | | |
| A,D | EP-A-0 169 802 (BRANDSCHUTZ) <br> ----- | | |

| RECHERCHIERTE SACHGEBIETE (Int. Cl.4) |
|---|
| E 04 H <br> E 06 B <br> H 05 K |

Der vorliegende Recherchenbericht wurde für alle Patentansprüche erstellt

| Recherchenort | Abschlußdatum der Recherche | Prüfer |
|---|---|---|
| DEN HAAG | 10-11-1988 | SCHOLS W.L.H. |